# EUROPEAN PATENT APPLICATION

(11) **EP 1 791 068 A2**
(43) Date of publication of application: **30.05.2007**
(21) Application number: 06005329.5
(22) Date of filing: 15.03.2006
(51) Int. Cl.: G06F 17/50

(54) **CAD method with capability of correcting dimension line with changes, recording medium storing CAD program, and CAD apparatus thereof**

(30) Priority: 24.11.2005 JP 2005338749
(71) Applicant: FUJITSU LIMITED, Kawasaki-shi, Kanagawa 211-8588 (JP)
(72) Inventor: Tokumaru, Takayuki c/o Fujitsu Kyushu Sys.Eng.Ltd., Sawara-ku Fukuoka-shi Fukuoka 814-8589 (JP); Fukumura, Yuichiro c/o Fujitsu Kyushu Sys.Eng.Ltd., Sawara-ku Fukuoka-shi Fukuoka 814-8589 (JP)
(74) Representative: Sunderland, James Harry

(57) **Abstract**

When a user specifies a graphic element to which he or she wants to attach a dimension line in a drawing, a dimension-line creation instructing unit identifies the graphic-element ID. Then, the user specifies a position at which he or she wants to attach the dimension line in the specified graphic element. When the user specifies a point, the coordinate values of the specified point are acquired by the dimension-line creation instructing unit. Among points constituting the graphic element (constituent points), a constituent point that is nearest to the coordinate values replaces the acquired coordinate values. Position data regarding the constituent point is represented by an offset with respect to a reference point in the graphic element. A dimension-line creating unit determines an actual position at which the dimension line is to be actually created by using a predetermined method and creates the dimension-line data.

## Description

### BACKGROUND OF THE INVENTION

### 1. Field of the Invention

The present invention relates to computer-aided design (CAD) methods, and in particular, to a CAD method for realizing a CAD apparatus capable of automatically correcting a dimension-line data in accordance with an editing process in a CAD drawing.

### 2. Description of the Related Art

CAD apparatuses store data on shapes of mechanical parts or other components and create drawings, such as part drawings, on the basis of the stored data. In the drawings (e.g., part drawings) created by the CAD apparatuses, dimension lines are drawn in some cases. For drawing a dimension line, automatically drawing the dimension line by specifying a graphic element in a drawing is widely used. When the graphic element in the drawing is edited, the dimension-line data relating to the graphic element is required to be corrected. Since the task of correction is complicated, it is desirable for a CAD apparatus to have a capability of automatically correcting the dimension-line data in accordance with a process of editing the graphic element for operability.

One approach to the capability is disclosed in Japanese Unexamined Patent Application Publication No. 5-189505. The technique disclosed in this published patent application covers automatic correction of a dimension line regarding only a section within a single graphic element.

### SUMMARY OF THE INVENTION

It is an object of the present invention to provide a CAD method for realizing a CAD apparatus that is capable of automatically correcting a dimension line for a dimension between different graphic elements in accordance with an editing process in an appropriate manner.

According to a first aspect of the present invention, a CAD method allows a computer to execute a graphic-element identifying step of identifying a specified graphic element, a coordinates acquiring step of acquiring specified coordinate values, a coordinates storing step of storing the acquired coordinate values in association with the identified graphic element, and a dimension-line creating step of creating data of a dimension line on the basis of two sets of the stored coordinate values.

In the CAD method, the association of the acquired coordinate values with the identified graphic element may be an association in which a point among points constituting the identified graphic element replaces the acquired coordinate values.

According to a second aspect of the present invention, a computer-readable storage medium that stores a CAD program that allows a computer to execute a graphic-element identifying step of identifying a specified graphic element, a coordinates acquiring step of acquiring specified coordinate values, a coordinates storing step of storing the acquired coordinate values in association with the identified graphic element, and a dimension-line creating step of creating data of a dimension line on the basis of two sets of the stored coordinate values.

In the storage medium, the association of the acquired coordinate values with the identified graphic element may be an association in which a point among points constituting the identified graphic element replaces the acquired coordinate values.

According to a third aspect of the present invention, a CAD apparatus capable of connecting to a peripheral device includes a graphic-element identifying means for identifying a specified graphic element, a coordinates acquiring means for acquiring specified coordinate values, a coordinates storing means for storing the acquired coordinate values in association with the identified graphic element, and a dimension-line creating means for creating data of a dimension line on the basis of two sets of the stored coordinate values.

In the CAD apparatus, the association of the acquired coordinate values with the identified graphic element may be an association in which a point among points constituting the identified graphic element replaces the acquired coordinate values.

Therefore, according to the embodiment, as the data regarding the position at which the dimension line is created corresponding to the graphic element to which the dimension line is attached, the coordinate values specified by the user are stored in association with the graphic element, and the specified coordinate values are edited with the editing process of the graphic element. As a result, automatically correcting a dimension-line data can be performed. Even for a dimension line between different graphic elements, the dimension-line data can be properly created so as to correspond with an edited graphic element.

### BRIEF DESCRIPTION OF THE DRAWINGS

Fig. 1 is a block diagram showing a schematic structure of a CAD system according to an embodiment of the present invention;
Figs. 2A and 2B are flowcharts of a process according to an embodiment of the present invention;
Figs. 3A to 3D show a first example of a data format of dimension-line data;
Figs. 4A to 4D show a first example of how to create a dimension line and correct the dimension line in accordance with an editing process;
Figs. 5A and 5B are flowcharts of a process according to another embodiment;
Figs. 6A and 6B show a second example of a data format of dimension-line data;
Figs. 7A to 7C show a second example of how to create a dimension line;
Figs. 8A to 8C show a second example of how to correct the dimension line in accordance with an editing process; and
Fig. 9 shows a typical computer environment.

### DESCRIPTION OF THE PREFERRED EMBODIMENTS

Embodiments are described below with reference to the attached drawings. The explanation for the embodiments below assumes a process flow of creating a dimension line in a prepared part drawing and then editing a graphic element.

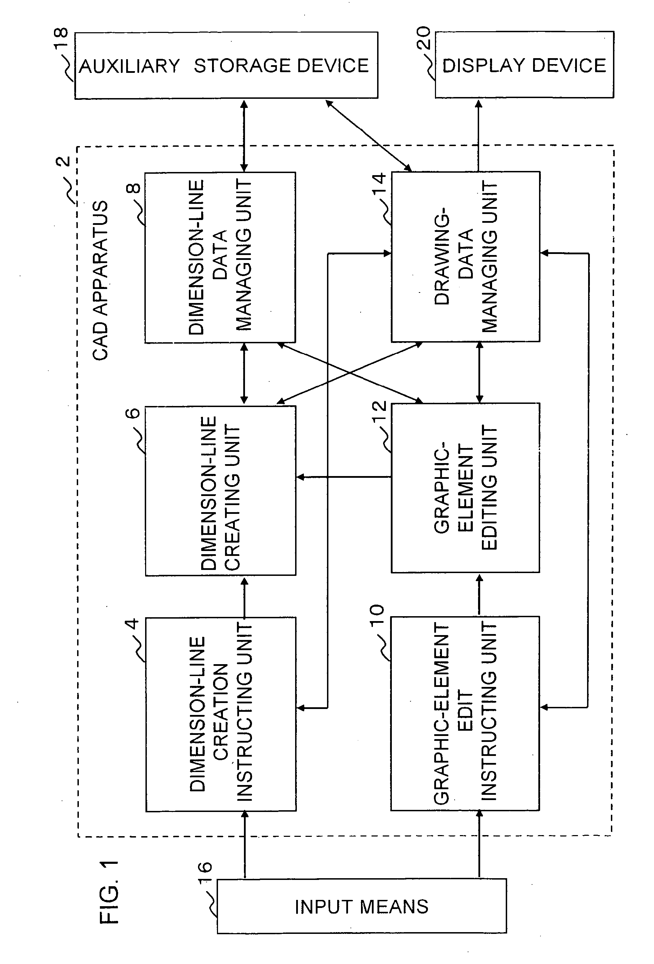

Fig. 1 is a block diagram showing a schematic structure of a CAD system according to an embodiment of the present invention. A CAD apparatus 2 includes a dimension-line creation instructing unit 4 for accepting specifications of a graphic element and a position at which a dimension line is to be created, a dimension-line creating unit 6 for creating the dimension-line data after receiving an ID of the graphic element and specified coordinate values in a drawing from the dimension-line creation instructing unit 4, a dimension-line data managing unit 8 for managing the dimension-line data created by the dimension-line creating unit 6, a graphic-element edit instructing unit 10 for accepting a specification of a graphic element and an instruction to edit the graphic element, a graphic-element editing unit 12 for editing the graphic element after receiving an ID of the graphic element in the drawing and details regarding the edit instruction from the graphic-element edit instructing unit 10, and a drawing-data managing unit 14 for managing drawing data, reflecting a result of the editing process performed by the graphic-element editing unit 12 and a result of the creation process performed by the dimension-line creating unit 6 in the drawing, and displaying the drawing on a display device 20. The CAD apparatus 2 is connected to input means 16 for accepting an input from a user, an auxiliary storage device 18 for storing the drawing data and the dimension-line data, and the display device 20 for displaying drawing on the basis of the drawing data created by the CAD apparatus 2.

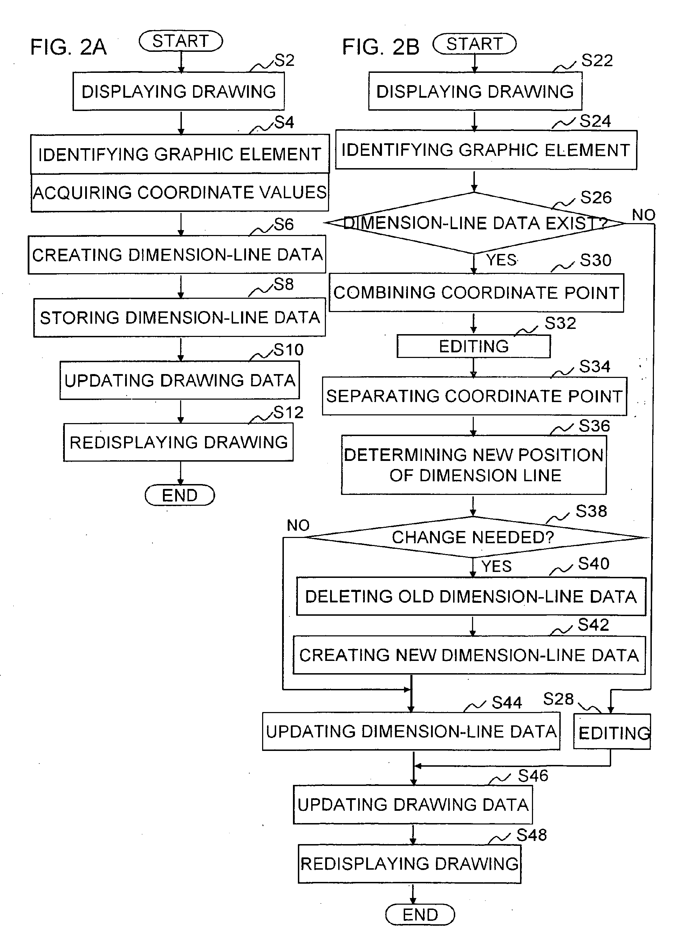

Figs. 2A and 2B are flowcharts of a process according to an embodiment of the present invention. The process flow according to the embodiment of the present invention is described below with reference to the flowcharts of Figs. 2A and 2B.

Fig. 2A is a flowchart of a creation process of a dimension line. The drawing-data managing unit 14 reads drawing data from the auxiliary storage device 18 and displays drawing on the basis of the drawing data on the display device 20 (step S2). A data format of the drawing data stored in the auxiliary storage device 18 is of any format known to those skilled in the art, so the explanation thereof is omitted here. Each graphic element is identified by an assigned graphic-element ID for uniquely identifying each graphic element in the drawing. The graphic element is typically a line segment used for describing a part or the like in the drawing, and can be defined freely. Examples of the graphic element include a line element (e.g., a straight line, a circle, a segment of a circle, an ellipse, a segment of an ellipse, a spline curve (free-form curve)), a plane element defined by one or more line elements, and a three-dimensional element (e.g., a part) defined by the plane elements. When a user specifies a graphic element to which he or she wants to attach a dimension line in the drawing, the dimension-line creation instructing unit 4 receives the specification and identifies the graphic-element ID of the specified graphic element (step S4). The method for specifying the graphic element is of any method known to those skilled in the art. For example, when the user specifies a point, a graphic element nearest to the coordinates of the point is specified. In this case, the dimension-line creation instructing unit 4 acquires the coordinate values of the specified point, inquires of the drawing-data managing unit 14 for the graphic element nearest to the acquired coordinate values, and acquires the graphic-element ID of the graphic element.

After the graphic element is specified, the user specifies a position at which he or she wants to attach the dimension line in the specified graphic element. Since precisely specifying the position at which the dimension line is to be created is difficult, the user specifies a point, the dimension-line creation instructing unit 4 acquires the coordinate values of the specified point (step S4); and, on the basis of the coordinate values, the dimension-line creating unit 6 determines an actual position at which the dimension line is to be actually created.

The graphic element and the position at which the dimension line is to be created can be separately specified by the user, as described above, and they may be simultaneously specified by the user. For example, after a graphic element that is nearest to the coordinate values of a point specified by the user is considered to be specified, the coordinate values can be used as specification data regarding the position at which the dimension line is to be created corresponding to the specified graphic element. Since each dimension line represents the relationship between two points, the user usually specifies two places at which the dimension line is to be created. With respect to the graphic element, the user can specify two different graphic elements or the same graphic element.

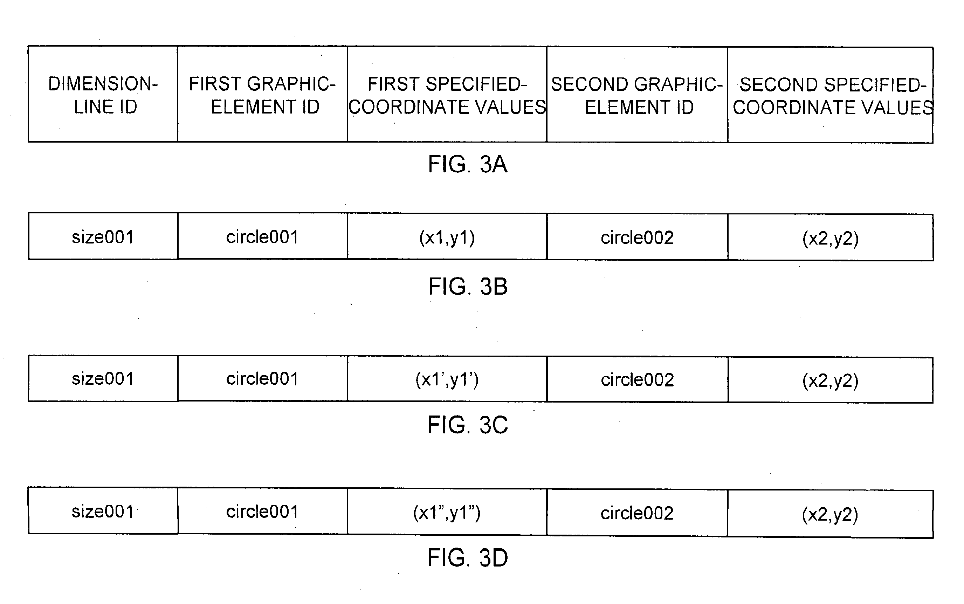

The dimension-line creating unit 6 receives the graphic-element ID and the specified coordinate values from the dimension-line creation instructing unit 4. The dimension-line creating unit 6 determines the actual position at which the dimension line is to be actually created by using a predetermined method and creates data regarding the dimension line (step S6). The method for creating dimension-line data and the method for adjusting the length of a leader line and the place for writing a dimension value are of any method known to those skilled in the art, so the explanation thereof is omitted here. The dimension-line data is stored in the auxiliary storage device 18 by the dimension-line data managing unit 8 (step S8) and managed. A first example of a data format of dimension-line data is illustrated in Figs. 3A to 3D. Fig. 3A shows the form of the data format of the dimension-line data in the first example. In this example, each dimension-line ID, which uniquely identifies each dimension line in a drawing, is stored in association with a first graphic-element ID, first specified-coordinate values, a second graphic-element ID, and second specified-coordinate values. The first graphic-element ID and the first specified-coordinate values are information indicating a first end of the dimension line. The second graphic-element ID and the second specified-coordinate values are information indicating a second end of the dimension line. Figs. 3B to 3D show concrete cases of the data format of the dimension-line data.

The created dimension-line data is added to the drawing data. The drawing-data managing unit 14 updates the drawing data, stores the updated drawing data in which the dimension-line data has been added in the auxiliary storage device 18 (step S10), and manages the drawing data. The drawing-data managing unit 14 redisplays drawing on the basis of the drawing data in which the dimension-line data has been added on the display device 20 (step S12).

Fig. 2B is a flowchart of a process occurring when a graphic element is edited. First, the drawing-data managing unit 14 reads the drawing data from the auxiliary storage device 18 and displays drawing on the basis of the drawing data on the display device 20 (step S22). If the process shown in the flowchart of Fig. 2B is performed subsequently to that of Fig. 2A, step S22 is omitted. The user specifies a graphic element that he or she wants to edit. In response to this specification, the graphic-element edit instructing unit 10 identifies the graphic-element ID of the specified graphic element (step S24). The method for specifying the graphic element and the method for identifying the graphic-element ID are, for example, the methods described above in the explanation for the process of creation of the dimension line. The graphic-element editing unit 12 inquires of the dimension-line data managing unit 8 whether a dimension-line data associated with the graphic element having the identified graphic-element ID is present or not. If no dimension-line data associated with the graphic element having the identified graphic-element ID is present (No in step S26), the graphic-element editing unit 12 simply edits the graphic element (step S28). The drawing-data managing unit 14 updates the drawing data, stores the updated drawing data in which the edited graphic element has been reflected in the auxiliary storage device 18 (step S46), and redisplays drawing on the basis of the drawing data on the display device 20 (step S48). The method for providing an edit instruction and the method for editing the graphic element are of any method known to those skilled in the art, so the explanation thereof is omitted here.

If the dimension-line data associated with the graphic element having the identified graphic-element ID is present (Yes in step S26), the graphic-element editing unit 12 receives the specified coordinate values associated with the graphic element from the dimension-line data managing unit 8 and combines a point that lies at the coordinate values with the graphic element (step S30), and edits the graphic element with which the point has been combined (step S32). The combination can be realized by any method. For example, the relative relationship between the specified coordinates and the graphic element can be maintained by setting a reference point in the graphic element and representing the specified coordinate values as an offset with respect to the reference point.

After the graphic element is edited, the point element is separated from the graphic element with which the point has been combined, and the specified coordinate values are reset to the coordinate values of the separated point element (step S34). The dimension-line creating unit 6 determines a position at which a new dimension line is to be created by using a predetermined method (step S36). If the position at which the current dimension line is created is different from the position of the new dimension line, the dimension-line creating unit 6 determines that the current dimension-line data is required to be changed. If there is a necessity to change the current dimension-line data (Yes in step S38), the dimension-line creating unit 6 deletes the current dimension-line data relating to the graphic element before being edited (step S40), and the new dimension-line data relating to the graphic element after being edited is created (step S42). The dimension-line data managing unit 8 updates the dimension-line data and stores the updated dimension-line data in the auxiliary storage device 18 (step S44). The drawing-data managing unit 14 updates the drawing data and stores the updated drawing data in which the edited graphic element has been reflected in the auxiliary storage device 18 (step S46), and redisplays drawing on the basis of the drawing data on the display device 20 (step S48).

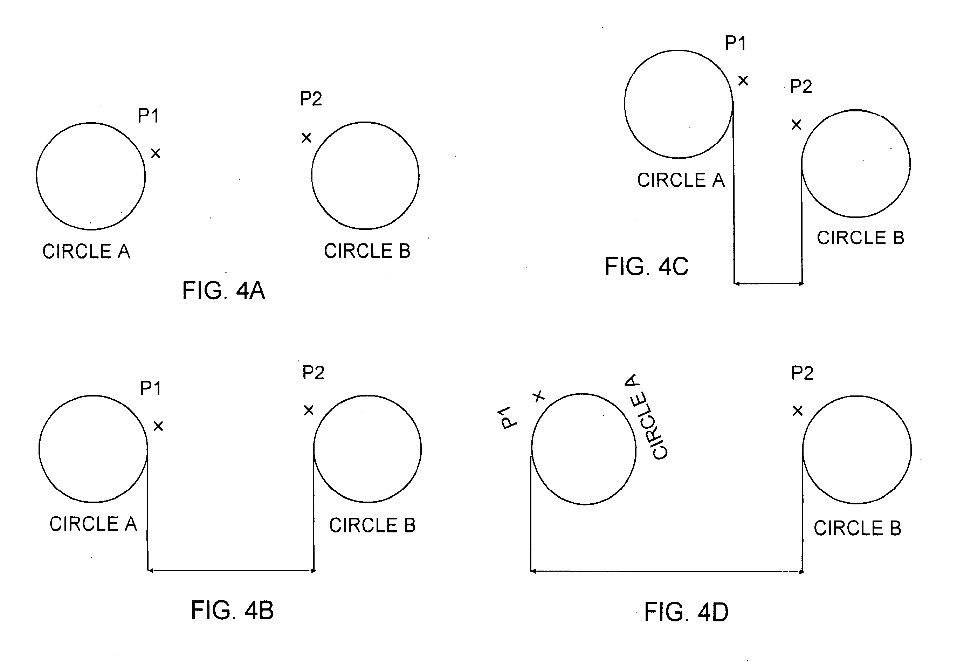

A concrete case is described below. Figs. 4A to 4D show a first example of how to create a dimension line and correct the dimension line in accordance with an editing process. In this example, a two-dimensional drawing consisting of a line element is targeted, and data regarding a dimension line that indicates the distance of a gap between two circles is created. As shown in Fig. 4A, when a user specifies point P1 and then specifies point P2, data regarding a dimension line between a first end in circle A and a second end in circle B is created in such a way that the first end is adjacent to point P1 and the second end is adjacent to point P2.

The relation between a position indicated by point P1 specified by the user and an actual position at which the first end point of the dimension line is actually created in circle A is formed by determining the direction of point P1 as seen from the center of circle A, which is a target for setting the dimension line, (e.g., right, left, top, or bottom direction) and setting a point on the circumference of circle A that is farthest from the center in the determined direction as the first end point of the dimension line. The relationship between a position indicated by point P2 and an actual position at which the second end point of the dimension line is actually created in circle B is formed in a similar manner. As a result, the dimension line is created as shown in Fig. 4B.

Where the dimension-line ID of the newly created dimension line is size001, the graphic-element ID of circle A is circle001, the graphic-element ID of circle B is circle002, the coordinates of P1 are (x1, y1), and the coordinates of P2 are (x2, y2), the dimension-line data that is stored in the auxiliary storage device 18 by the dimension-line data managing unit 8 is illustrated in Fig. 3B, for example.

After this, circle A is edited. When the user specifies circle A, the graphic-element edit instructing unit 10 identifies a graphic-element ID of circle001, and the graphic-element editing unit 12 inquires of the dimension-line data managing unit 8 whether a dimension-line data associated with the graphic element having the identified graphic-element ID circle001 is present. The dimension-line data managing unit 8 finds the dimension-line data with the dimension-line ID size 001 and returns the coordinates (x1, y1) associated with the graphic-element ID circle 001. The graphic-element editing unit 12 combines point P1 with circle A, and performs an editing process described below while maintaining the relative position between point P1 and the reference point in circle A. A case in which circle A is transferred is illustrated in Fig. 4C, and a case in which circle A is rotated is illustrated in Fig. 4D. With the editing process of circle A, point P1 is edited. Where the coordinates of point P1 in Fig. 4C are (x1', y1'), the dimension-line data with the dimension-line ID size001 is illustrated in Fig. 3C. Where the coordinates of point P1 in Fig. 4D are (x1", y1"), the dimension-line data with the dimension-line ID size001 is illustrated in Fig. 3D.

Therefore, according to the embodiment, as the data regarding the position at which the dimension line is created corresponding to the graphic element to which the dimension line is attached, the coordinate values specified by the user are stored in association with the graphic element, and the specified coordinate values are edited with the editing process of the graphic element. As a result, automatically correcting a dimension line can be performed. Even for a dimension line between different graphic elements, the dimension-line data can be properly created so as to correspond with an edited graphic element.

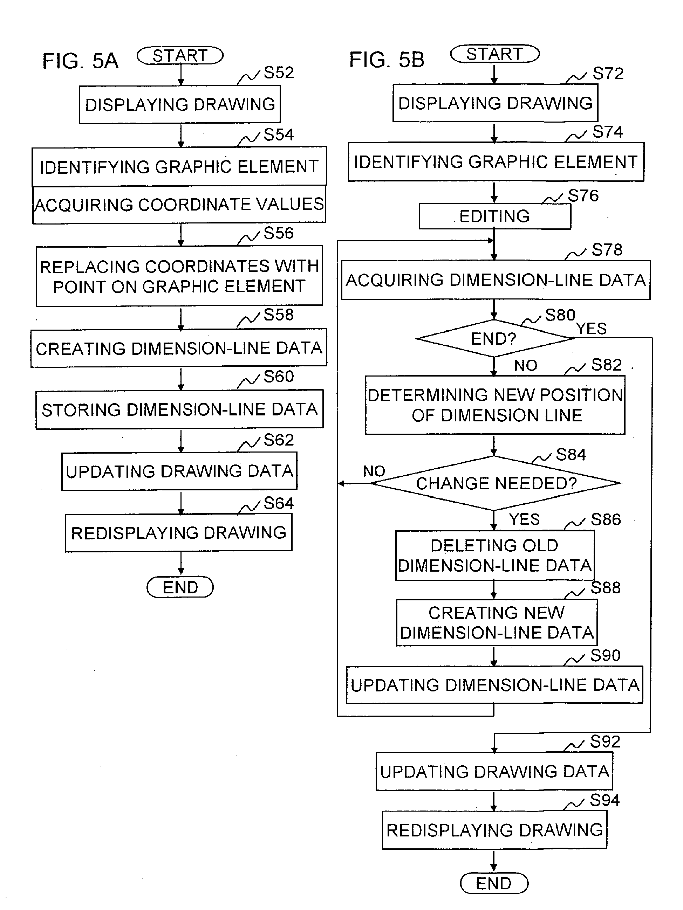

Figs. 5A and 5B are flowcharts of a process according to another embodiment. The process flow according to the embodiment of the present invention is described below with reference to the flowcharts of Figs. 5A and 5B. In this embodiment, a case is assumed in which, because an editing process of a first graphic element has an influence on a second graphic element, a dimension-line data associated with the second graphic element is automatically corrected in accordance with the editing process.

Fig. 5A is a flowchart of a creation process of the dimension line. The drawing-data managing unit 14 reads drawing data from the auxiliary storage device 18 and displays drawing on the basis of the drawing data on the display device 20 (step S52). A data format of the drawing data stored in the auxiliary storage device 18 is of any format known to those skilled in the art, so the explanation thereof is omitted here. Each graphic element is identified by an assigned graphic-element ID for uniquely identifying each graphic element in the drawing. When a user specifies a graphic element to which he or she wants to attach a dimension line in the drawing, the dimension-line creation instructing unit 4 identifies the graphic-element ID of the specified graphic element (step S54). The method for specifying the graphic element is of any method known to those skilled in the art. For example, when the user specifies a point, a graphic element nearest to the coordinates of the point is specified. In this case, the dimension-line creation instructing unit 4 acquires the coordinate values of the specified point, inquires of the drawing-data managing unit 14 for the graphic element nearest to the acquired coordinate values, and acquires the graphic-element ID of the graphic element.

After the graphic element is specified, the user specifies a position at which he or she wants to attach the dimension line in the specified graphic element. Since precisely specifying the position at which the dimension line is to be created is difficult, the user specifies a point, and the coordinate values of the specified point are acquired by the dimension-line creation instructing unit 4 (step S54). Among points constituting the graphic element (hereinafter referred to as constituent points), a constituent point that is nearest to the coordinate values replaces the acquired coordinate values (step S56). On the basis of the point, the actual position at which the dimension line is to be created is determined.

The graphic element and the position at which the dimension line is to be created can be separately specified by the user, as described above, and they may be simultaneously specified by the user. For example, after a graphic element that is nearest to the coordinate values of a point specified by the user is considered to be specified, the coordinate values can be used as specification data regarding the position at which the dimension line is to be created corresponding to the specified graphic element. Since each dimension line represents the relationship between two points, the user usually specifies two places at which the dimension line is to be created. With respect to the graphic element, the user can specify two different graphic elements or the same graphic element.

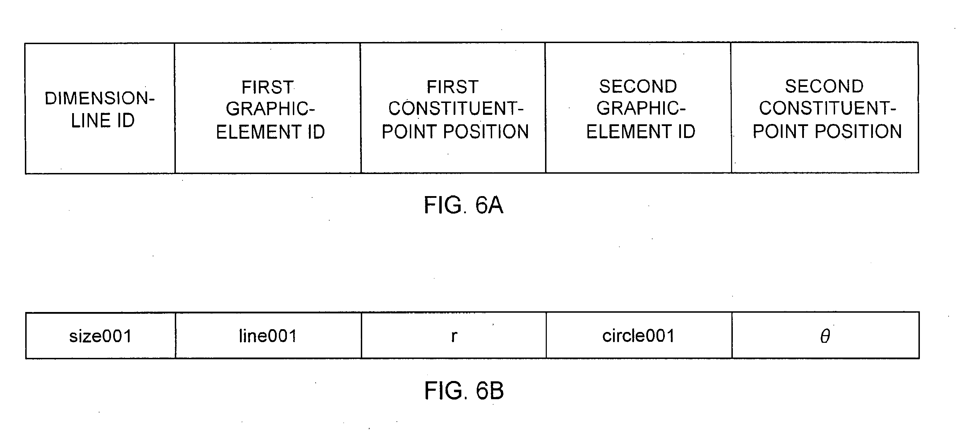

The dimension-line creating unit 6 receives the graphic-element ID and position data regarding the constituent point replacing the specified coordinates from the dimension-line creation instructing unit 4. The position data regarding the constituent point is represented by relative coordinates in the graphic element. In other words, the position data regarding the constituent point is represented by an offset with respect to a reference point in the graphic element. The dimension-line creating unit 6 determines the actual position at which the dimension line is to be actually created by using a predetermined method and creates data regarding the dimension line (step S58). The method for creating the dimension-line data and the method for adjusting the length of a leader line and the place for writing a dimension value are of any method known to those skilled in the art, so the explanation thereof is omitted here. The dimension-line data is stored in the auxiliary storage device 18 by the dimension-line data managing unit 8 (step S60) and managed. A second example of a data format of dimension-line data is illustrated in Figs. 6A and 6B. Fig. 6A shows the form of the data format of the dimension-line data in the second example. In this example, each dimension-line ID, which uniquely identifies each dimension line in a drawing, is stored in association with a first graphic-element ID, a first constituent-point position, a second graphic-element ID, and a second constituent-point position. The first graphic-element ID and the first constituent-point position are information indicating a first end of the dimension line. The second graphic-element ID and the second constituent-point position are information indicating a second end of the dimension line. Fig. 6B shows a concrete case of the data format of the dimension-line data.

The created dimension-line data is added to the drawing data. The drawing-data managing unit 14 updates the drawing data, stores the updated drawing data in which the dimension-line data has been added in the auxiliary storage device 18 (step S62), and manages the drawing data. The drawing-data managing unit 14 redisplays drawing on the basis of the drawing data in which the dimension-line data has been added on the display device 20 (step S64).

Fig. 5B is a flowchart of a process occurring when a graphic element is edited. First, the drawing-data managing unit 14 reads the drawing data from the auxiliary storage device 18 and displays drawing on the basis of the drawing data on the display device 20 (step S72). If the process shown in the flowchart of Fig. 5B is performed subsequently to that of Fig. 5A, step S72 is omitted. The user specifies a graphic element that he or she wants to edit. In response to this specification, the graphic-element edit instructing unit 10 identifies the graphic-element ID of the specified graphic element (step S74). The method for specifying the graphic element and the method for identifying the graphic-element ID are, for example, the methods described above in the explanation for the process of creation of the dimension line. The graphic-element editing unit 12 edits the specified graphic element (step S76). At this time, with the edit processing, other graphic elements are simultaneously edited. The method for editing the graphic element is of any method known to those skilled in the art, the explanation thereof is omitted here.

The dimension-line creating unit 6 receives the dimension-line data from the dimension-line data managing unit 8 (step S78) and determines a new position at which the dimension line is to be added (step S82) by using a predetermined method. If the current position of the dimension line is different from the new position, the dimension-line creating unit 6 determines that the current dimension-line data is required to be changed. If there is a necessity to change the current dimension-line data (Yes in step S84), the dimension-line creating unit 6 deletes the current dimension-line data (step S86) and creates the new dimension-line data (step S88). The dimension-line data managing unit 8 receives the dimension-line data from the dimension-line creating unit 6, updates the data, and stores the updated data in the auxiliary storage device 18 (step S90). After necessary changes are executed on all the dimension-line data (Yes in step S80), the drawing-data managing unit 14 updates the drawing data and stores the updated drawing data in which the edited graphic element has been reflected in the auxiliary storage device 18 (step S92), and redisplays drawing on the basis of the drawing data on the display device 20 (step S94).

In some cases, by a partial deletion of the graphic element, the constituent point replacing the specified coordinates is lost. In such cases, the old dimension-line data is deleted, and the new dimension-line data is not created. Alternatively, in such cases, the old dimension line may be highlighted to call the attention of the user to that the dimension-line data will be lost. If there are multiple dimension-line data that will be lost, all the dimension-line data may be deleted collectively in response to an instruction from the user.

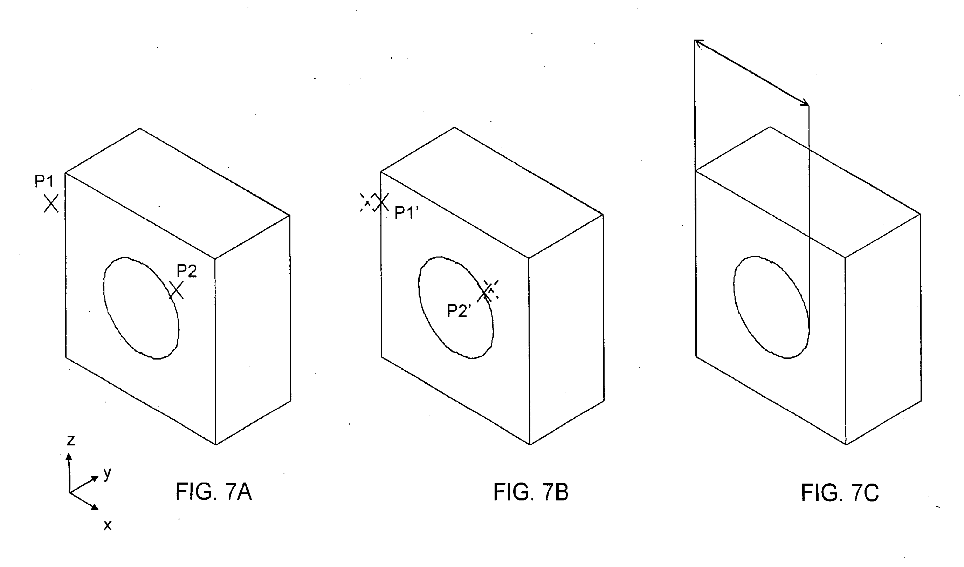

A concrete case is described below. In this case, a three-dimensional drawing is targeted. Figs. 7A to 7C show a second example of how to create a dimension line. Figs. 8A to 8C show a second example of how to correct the dimension line in accordance with an editing process. As shown in Fig. 7A, when the user specifies point P1 and then specifies point P2, point P1 and point P2 are replaced with constituent point P1' and constituent point P2', which are constituent points of the respective adjacent graphic elements, respectively, as shown in Fig. 7B. Position data regarding the constituent point replacing the specified coordinates is represented by an offset with respect to a reference point in the graphic element. The definition of the offset may be of any definition as long as the position of the constituent point replacing the specified coordinates is uniquely determined. In the case of a straight line element, when a first end is set as a reference point, the ratio of the distance from the reference point to the entire distance of the straight line is determined as the offset, for example. In the case of a circle element, when a point on the circumference of the circle is set as the reference point, the angle between a radius that passes through the reference point and a radius that passes through the constituent point replacing the specified coordinates is determined as the offset, for example. On the basis of the position data regarding the constituent point replacing the specified coordinates, the dimension-line data is created. Although the relation between the constituent point replacing the specified coordinates and the position at which the dimension line is actually created, i.e., how to correlate them, is a matter of design, for this case, data regarding the dimension line between a straight line that contains point P1' and the right end of a circle that contains point P2' is created, as shown in Fig. 7C. Where the dimension-line ID of the created dimension line is size001, the graphic-element ID of the straight line that contains point P1' is line001, the graphic-element ID of the circle that contains point P2' is circle001, the position data regarding point P1' is r, and the position data regarding point P2' is θ, the dimension-line data stored in the auxiliary storage device 18 by the dimension-line data managing unit 8 is illustrated in Fig. 6B.

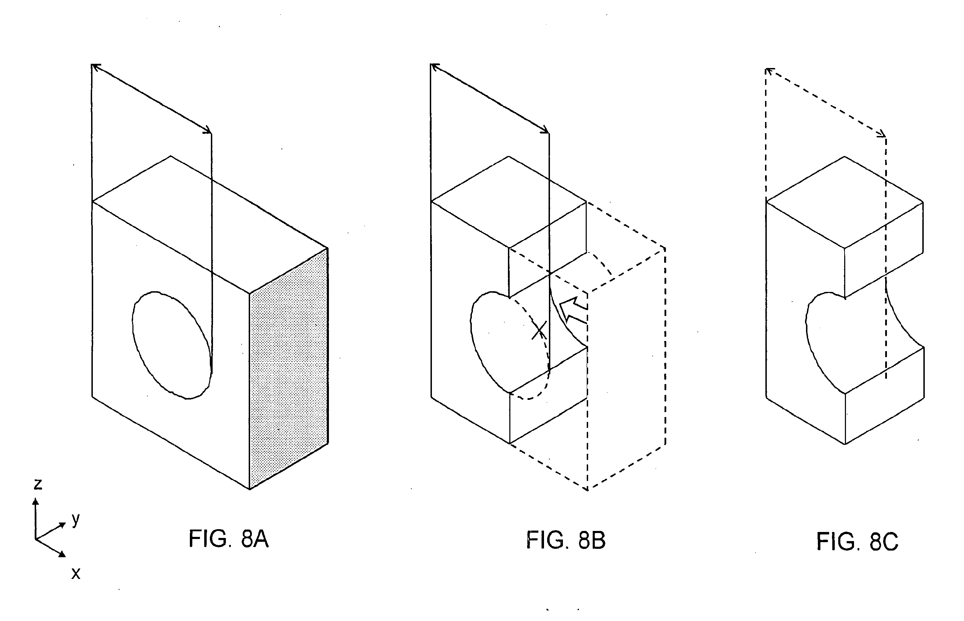

After this, a right plane in Fig. 8A is edited. When the right plane is transferred as shown in Fig. 8B, other graphic elements are automatically edited together with this movement. After the edit process, the necessity of changes is checked through all dimension-line data. In Fig. 8B, the circle element is partially deleted, and the constituent point replacing the specified coordinates is present within the portion that will be deleted. As a result, the dimension-line data is not created after the editing process. In this case, the dimension-line data that is created before the editing process is deleted. Fig. 8C shows a state after the editing process. The dimension line whose data is created before the editing process is indicated by dashed lines, representing that the dimension-line data will be lost. This indication is performed in order to call the attention of the user to that the dimension-line data will be lost. The way for indicating the dimension line whose data will be lost may be of any way as long as it can call the attention of the user. For example, the color or the brightness may be changed, or the dimension line may be indicated by flashing lines. Alternatively, the dimension line may be deleted together with the editing process without being highlighted.

In the embodiment, the position at which the dimension line is to be created is stored by storing the constituent point in the graphic element replacing the coordinates of the point specified by the user, instead of storing the coordinates of the point specified by the user as they are. Therefore, the information relating to the creation of the dimension line is automatically edited with the editing process of the graphic element, so that editing the specified coordinates every time the graphic element is edited is not necessary. Additionally, the user can easily grasp a case in which the constituent point replacing the specified coordinates is lost by the partial deletion of the graphic element.

The CAD apparatus according to the embodiments can be realized as not only hardware but also software in a computer. For example, the CAD apparatus can be realized by creating a program that allows the computer to perform the functions of the dimension-line creation instructing unit 4, the dimension-line creating unit 6, the dimension-line data managing unit 8, the graphic-element edit instructing unit 10, the graphic-element editing unit 12, and the drawing-data managing unit 14, which are shown in Fig. 1 and reading the program in a memory in the computer and executing the program by the computer.

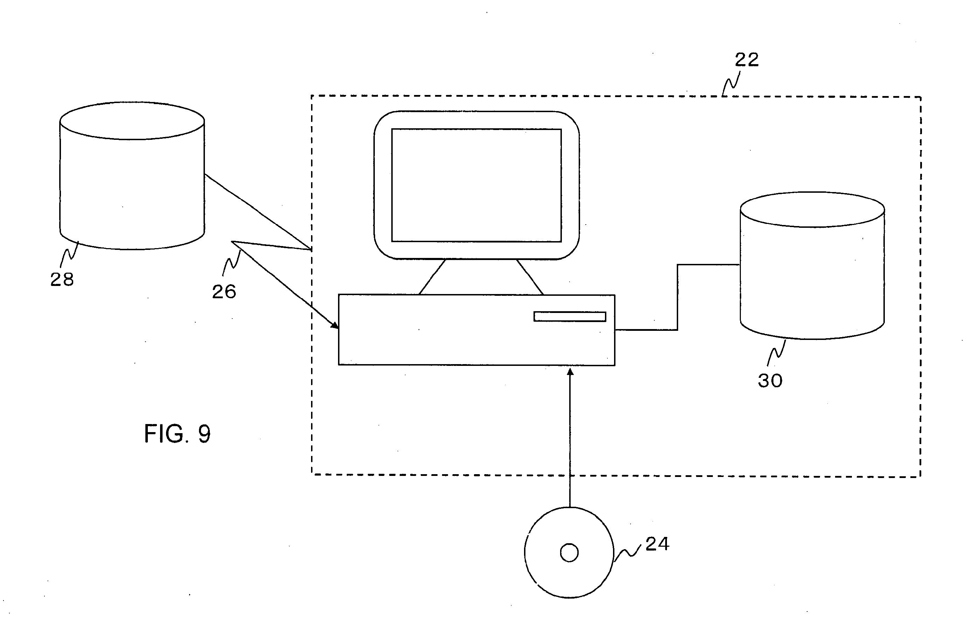

As shown in Fig. 9, the program for realizing the CAD apparatus may be stored in not only a portable recording medium 24 (e.g., compact disc read-only memory (CD-ROM), a CD-rewritable (CD-RW), a digital versatile disc recordable (DVD-R), a DVD random access memory (DVD-PAM), and a DVD-rewritable (DVD-RW)) but also a storage device 28 connected to a communication line 26, and a storage device/recording medium 30 (e.g., a hard disk and RAM) in a computer system 22. For executing the program, the program is loaded and executed in a main memory.

## Claims

1. A method for computer aided design, comprising:
a graphic-element identifying step of identifying a specified graphic element;
a coordinates acquiring step of acquiring specified coordinate values;
a coordinates storing step of storing the acquired coordinate values in association with the identified graphic element; and
a dimension-line creating step of creating data of a dimension line on the basis of two sets of the stored coordinate values.

2. The method of claim 1, wherein
said association of the acquired coordinate values with the identified graphic element is an association in which a point among points constituting the identified graphic element replaces the acquired coordinate values.

3. A program storage medium readable by a computer, tangibly embodying a program of instructions executable by the computer to perform method steps of computer aided design, said method comprising:
a graphic-element identifying step of identifying a specified graphic element;
a coordinates acquiring step of acquiring specified coordinate values;
a coordinates storing step of storing the acquired coordinate values in association with the identified graphic element; and
a dimension-line creating step of creating data of a dimension line on the basis of two sets of the stored coordinate values.

4. The program storage medium of claim 3, wherein
said association of the acquired coordinate values with the identified graphic element is an association in which a point among points constituting the identified graphic element replaces the acquired coordinate values.

5. An apparatus for computer aided design connectable to a peripheral device, comprising:
a graphic-element identifying means for identifying a specified graphic element;
a coordinates acquiring means for acquiring specified coordinate values;
a coordinates storing means for storing the acquired coordinate values in association with the identified graphic element; and
a dimension-line creating means for creating data of a dimension line on the basis of two sets of the stored coordinate values.

6. The apparatus of claim 5, wherein
said association of the acquired coordinate values with the identified graphic element is an association in which a point among points constituting the identified graphic element replaces the acquired coordinate values.
